Europäisches Patentamt

European Patent Office

Office européen des brevets

(11) Publication number: **0 140 567 B1**

# EUROPEAN PATENT SPECIFICATION

(45) Date of publication of patent specification: **23.10.91**     (51) Int. Cl.5: **H03L 7/10**

(21) Application number: **84306429.6**

(22) Date of filing: **20.09.84**

(54) Apparatus for controlling the frequency of a voltage controlled oscillator.

(30) Priority: **21.09.83 JP 174777/83**
**21.09.83 JP 174778/83**

(43) Date of publication of application:
**08.05.85 Bulletin 85/19**

(45) Publication of the grant of the patent:
**23.10.91 Bulletin 91/43**

(84) Designated Contracting States:
**AT DE FR GB NL**

(56) References cited:
**GB-A- 2 090 101**

**IBM TECHNICAL DISCLOSURE BULLETIN, vol.
23, no. 1, June 1980, pages 81-82, New York,
US; M.L. CARNES et al.: "Cycle-synchronized
phase-locked loop"**

(73) Proprietor: **SONY CORPORATION**
**7-35 Kitashinagawa 6-Chome Shinagawa-ku
Tokyo 141(JP)**

(72) Inventor: **Kikuchi, Akihiro c/o Patent Division
Sony Corporation 7-35, Kitashinagawa
6-chome
Shinagawa-ku Tokyo(JP)**

(74) Representative: **Cotter, Ivan John et al
D. YOUNG & CO. 10 Staple Inn
London WC1V 7RD(GB)**

## Description

This invention relates to apparatus for controlling the frequency of a voltage controlled oscillator for use in, for example, a video tape recorder (VTR).

In a previously proposed colour signal processing circuit of a VTR, a carrier chrominance signal (having a frequency of 3.58 MHz) is frequency-converted to a low frequency converted chrominance signal (having a frequency fs = 743 kHz) and then recorded on a magnetic tape, while, upon playback, the reproduced low frequency converted chrominance signal is frequency-converted to a reproduced carrier chrominance signal (having a frequency fc = 3.58 MHz), thus making the usable frequency band narrow. In the above -described previously proposed frequency conversion arrangement, a voltage controlled oscillator (VCO) is frequency-controlled on the basis of a horizontal sync (synchronising) signal separated from an input video signal and the frequency conversion is carried out by a frequency output signal derived from the VCO, which is controlled as above. Thus, the frequency converted output can be produced on the basis of the frequency signal which is locked to the frequency of the horizontal synchronising signal. This frequency control circuit is a so-called automatic frequency control (AFC) circuit.

When the VCO is used to carry out the frequency conversion operation by using the frequency signal which is locked to the frequency of the horizontal synchronising signal, if the range of frequency variation of the VCO is wide, for example, the oscillation frequency of the VCO differs greatly from the frequency of the horizontal synchronising signal upon starting, as a result of which there is a risk that the oscillation frequency of the VCO cannot be locked to the frequency of the horizontal synchronising signal. To remove this shortcoming, it has been proposed to use a VCO which is adjusted such that its range of frequency variation is set to fall within a predetermined narrow range.

However, when such a previously proposed VCO is formed on an integrated circuit (IC), if the parameters thereof are scattered the change of the oscillation frequency of the VCO cannot be restricted to lie within a predetermined range, so that the yield of the manufacturing process thereof inevitably grows worse.

An article by M.L. Carnes et al, which is entitled "Cycle-Synchronized Phase-Locked Loop" and appears at pages 81 and 82 of IBM Technical Disclosure Bulletin, Vol. 23, No, 1, June 1980, New York, USA, discloses apparatus for controlling the frequency of a VCO in response to an input signal. The apparatus comprises frequency-divider means for dividing the frequency of an output of the oscillator, and control means for phase-comparing output of the frequency-divider means with the input signal to produce an error signal and forming, from the error signal, a control signal for controlling the frequency of the oscillator. The control means includes a phase detector for producing the error signal, a control gate connected to receive the error signal, and a charge pump connected to receive the error signal, during normal operation (i.e. after lock up has been achieved), via the control gate. During lock-in, the control gate switches a magnitude comparison signal, instead of the error signal, to the charge pump. The magnitude comparison signal is obtained by comparing the outputs of two binary counters incremented by the input signal and the output of the frequency divider, respectively.

UK Patent application Publication No GB-A-2 090 101 discloses the use of a phase locked loop in a video tape recorder to synchronise a VCO with a horizontal synchronising signal of a video signal in order to provide frequency conversion of a carrier chrominance signal.

According to the present invention there is provided apparatus for controlling the frequency of a voltage controlled oscillator in response to an input signal, the apparatus comprising:

frequency-divider means for dividing the frequency of an output of the oscillator; and

control means for phase-comparing an output of the frequency-divider means with the input signal to produce an error signal and forming, from the error signal, a control signal for controlling the frequency of the oscillator;

characterised in that:

the control means is capable of effecting the phase comparison between the output of the frequency-divider means and the input signal which is a horizontal synchronising signal of a video signal;

the frequency-divider means is operative to establish a plurality of successive time windows;

the control means is operative to form the control signal by generating an error signal which assumes a first signal level in synchronism with the horizontal synchronising signal and thereafter assumes either the first signal level or a second signal level in each successive time window as necessary to form the control signal, the first and second levels both being different from a third level that will produce no change in the frequency of the oscillator, and the control signal being formed in accordance with the difference in the durations of the intervals in which the error signal assumes the first and second levels so that the control signal controls the frequency of the oscillator in accordance with the frequency of the horizontal synchronising signal; and

correction signal generating means is provided for forming a correcting signal to be added to the error signal when the phase of the horizontal synchronising signal is beyond a predetermined range.

As explained in more detail hereinbelow, such an apparatus has the advantageous effects that: it is suitable for being formed as an integrated circuit; it can achieve high accuracy in phase lock-in operation and a small amount of ripple after lock-in has been achieved; and it can easily be locked to the horizontal synchronising signal.

A preferred embodiment of this invention described hereinbelow is suitable for use in a video tape recorder and, also (as just mentioned), is suitable for being formed as an integrated circuit. The preferred apparatus is capable of carrying out automatic frequency control operation with high precision. Further, in the preferred apparatus, even when the frequency of the voltage controlled oscillator is changed over a wide range, its oscillation frequency can be locked easily to the frequency of the horizontal synchronising signal.

The invention will now be further described, by way of illustrative and non-limiting example, with reference to the accompanying drawings, in which like references designate like elements and parts throughout, and in which:-

Figure 1 is a block diagram of a frequency control circuit or apparatus embodying this invention;

Figures 2A, 2B, Figures 3A, 3B, Figures 4A, 4B and 4C1 to 4C47 are waveform diagrams showing signals at respective parts of the frequency control circuit shown in Figure 1;

Figure 5 is a block diagram showing in detail an automatic frequency control circuit used in the circuit shown in Figure 1;

Figures 6A to 6J are waveform diagrams of signals used in respective circuit elements of the automatic frequency control circuit shown in Figure 5;

Figure 7 is a block diagram showing in detail an automatic frequency control identification circuit used in the circuit shown in Figure 1; and

Figures 8A to 8E are waveform diagrams for explaining the operation of the automatic frequency control identification circuit shown in Figure 7.

A frequency control circuit or apparatus embodying the present invention will now be described in detail with reference to the accompanying drawings. In this embodiment, the frequency control circuit is applied to an automatic frequency control (AFC) circuit used by a chrominance signal system in a recording circuit of a video tape recorder (VTR).

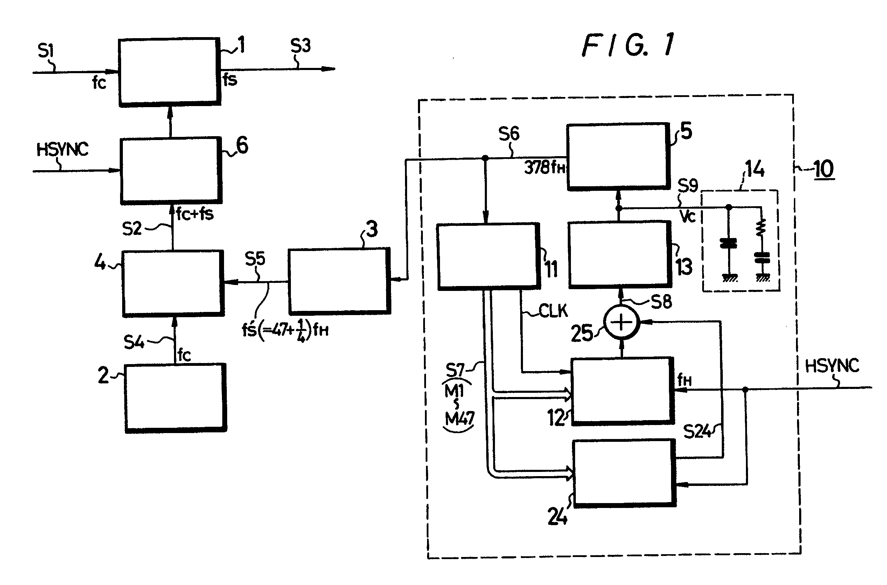

Figure 1 is a block diagram of the frequency control circuit embodying the present invention. As shown in Figure 1, a carrier chrominance signal S1 (having a frequency fc), obtained from an input video signal supplied through an automatic chroma level control (ACC) circuit is supplied to a frequency converting circuit 1 in which it is frequency-converted to a low frequency converted chrominance signal S3 (having a frequency fs) in response to a carrier signal S2. The low frequency converted chrominance signal S3 is recorded together with a luminance signal on a magnetic tape (not shown).

The carrier signal S2 results from frequency-converting an oscillation output S4 (having a frequency fc) of a quartz oscillator 2 by a frequency output signal S5 (having a frequency fs') derived from a 1/8 frequency-dividing circuit 3 in a carrier frequency converting circuit 4. The carrier signal S2 is inverted in phase by a phase inverting (PI) circuit 6 and then supplied to the frequency converting circuit 1. The carrier frequency converting operation is carried out such that interference from beat noise due to cross modulation distortion with a frequency modulated (FM) luminance signal appearing in a reproduced luminance signal is reduced by an interleave effect.

An oscillation output 56 (having a frequency 378 $f_H$, where $f_H$ is the frequency of a horizontal synchronising signal) of a voltage controlled oscillator (VCO) 5 is frequency-divided by the 1/8 frequency dividing circuit 3 such that the frequency fs' of the frequency signal S5 becomes $(47 + \frac{1}{4})f_H$.

The oscillation output S6 of the VCO 5 is required to have a frequency exactly 378 times the frequency $f_H$, namely the frequency of the horizontal synchronising signal. To this end, a frequency control circuit 10 is arranged as follows. In the frequency control circuit 10, the frequency output signal S6 of the VCO 5 is frequency-divided by a variable frequency divider 11 and its frequency-divided output S7 is compared with a horizontal synchronising signal HSYNC (having the frequency $f_H$) by an automatic frequency control (AFC) circuit 12. An AFC error signal S8 from the AFC circuit 12 drives an AFC current source 13 and controls its output current signal S9, thereby to control a voltage converting circuit 14. Then, an output voltage Vc of the voltage converting circuit 14 is supplied to the VCO 5 as the control signal thereof.

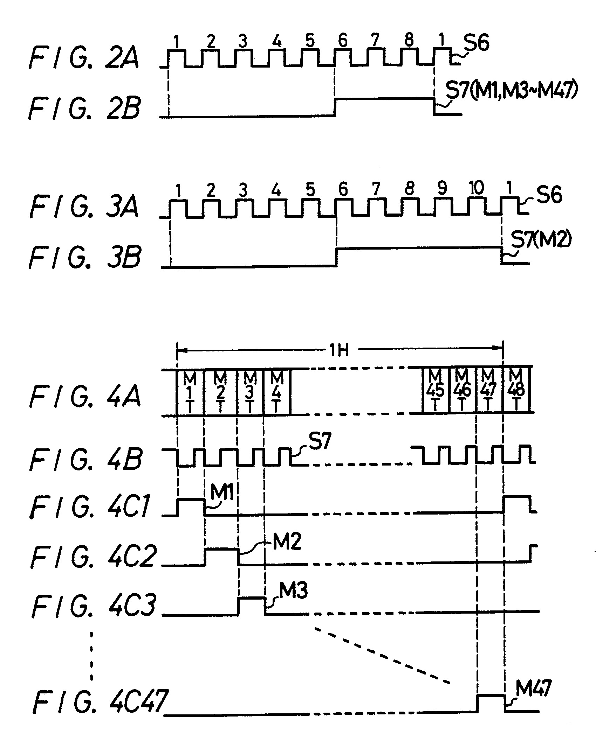

When the variable frequency divider 11 has counted pulses of the output signal S6 from the VCO 5 over 8 period amounts, as shown in Figure 2A, it produces a first output pulse M1, as the frequency-divided output S7, as shown in Figure 2B. Then, when the variable frequency divider 11 has counted pulses of the output signal S6 over 10 period amounts, as shown in Figure 3A, the variable frequency divider 11 produces a second pulse M2, as the frequency-divided output S7, as shown in Figure 38. Further, each time the variable frequency divider 11 has counted pulses of the frequency output S6 over 8 period amounts, as shown in Figure 2A, it produces third to forty-seventh pulses M3 to M47, respectively, as shown in Figure 2B. Accordingly, during the periods in which 46 pulses M1 and M 3 to M47 (except the second pulse M2) are produced, the variable frequency divider 11 counts the output signal S6 over 8 x 46 period amounts and counts the output signal S6 over 10 x 1 period amounts when the second pulse M2 is delivered, thus resulting in the frequency-divided output S7 having 47 pulses corresponding to amounts of (8 x 46 + 10 x 1) = 378 periods. As a result, the total period of the 47 pulses M1 to M47 becomes the period of the horizontal synchronising signal HSYNC, namely, 1H.

The pulses M1 to M47 (Figures 4C1 to 4C47) thus produced are respectively supplied to the AFC circuit 12 as 47 parallel line signals.

The reason why the output pulse M2 corresponding to 10 period amounts of the frequency output S6 is formed as the second frequency-divided output, as shown in Figures 3A and 3B, is that the oscillation frequency of the VCO 5 is selected to be 378 $f_H$ so as to process a television signal of the NTSC (National Television Systems Committee) system. Instead, when a television signal of the CCIR (International Radio Consultative Committee) system is processed, the oscillation frequency of the VCO 5 must be selected to be 375 $f_H$ so that, when the output signal S6 is counted over 7 period amounts, the variable frequency divider 11 produces the second frequency-divided output (corresponding to Figures 3A and 3B): thus, the frequency-divider 11 functions as a variable frequency divider.

As described above, each period interval of the frequency-divided output S7 from the variable frequency divider 11 means that one horizontal period interval 1H (shown in Figure 4A) of the horizontal synchronising signal HSYNC is provided with time windows M1T to M47T corresponding to the output pulses M1 to M47 as shown in Figures 4C1 to 4C47. The AFC circuit 12 uses the time windows M1T to M47T to detect at which of the time windows M1T to M47T the horizontal synchronising signal HSYNC rises up and produces an AFC error signal S8 corresponding to a time difference between the timing of the generation of the horizontal synchronising signal HSYNC and the predetermined time window.

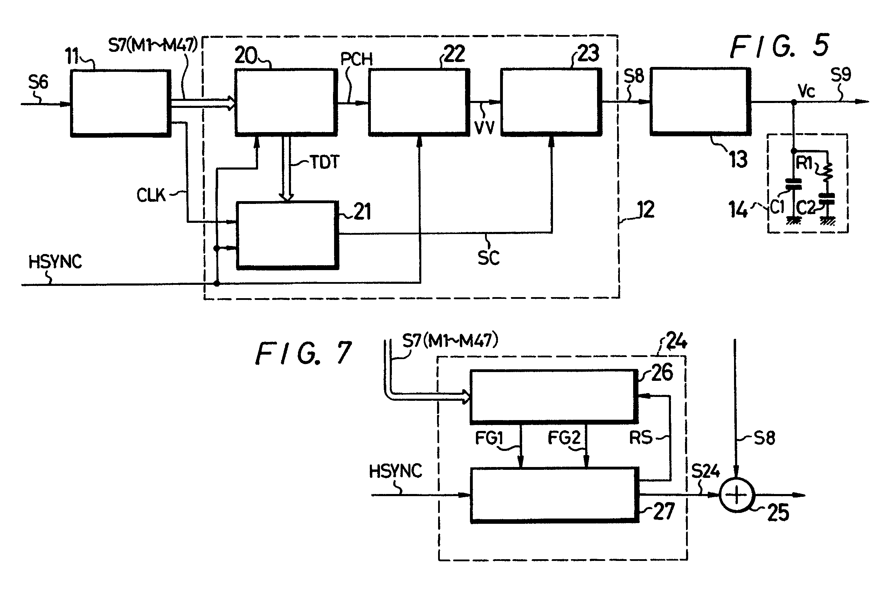

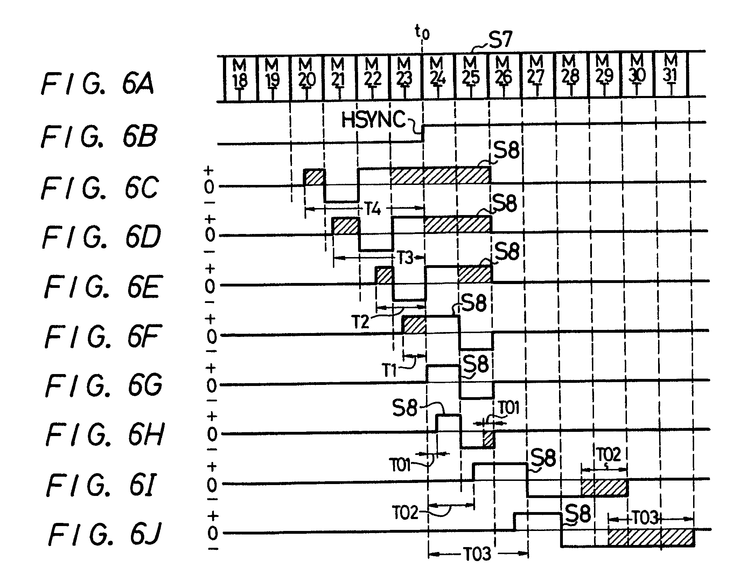

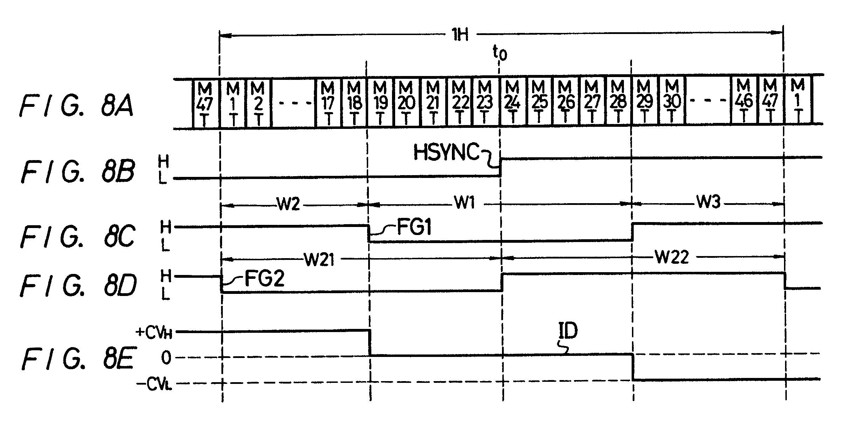

The AFC circuit 12, which is formed as shown in Figure 5, includes a decoder 20 which receives the frequency-divided output S7 of the variable frequency divider 11. Among the time windows of the frequency-divided output S7, a starting timing $t_0$ of the time window M24T is taken as a reference timing, as shown in Figure 6A. When the horizontal synchronising signal HSYNC (Figure 6B) rises up at the reference timing $t_0$, the decoder 20 judges that there is no AFC error. On the other hand, when the horizontal synchronising signal HSYNC rises up at the timing of a time window before or after the reference timing $t_0$, the decoder 20 carries out a judgement corresponding thereto and (i) supplies time data TDT having a content corresponding to the judged results to a shift register 21 and (ii) supplies a predetermined polarity order switching signal PCH, relating to the time window in which the horizontal synchronising signal HSYNC rises up and the succeeding time window, to a polarity switching circuit 22.

When the horizontal synchronising signal HSYNC rises up at the reference timing $t_0$, as shown in Figure 6B, the decoder 20 supplies to the polarity switching circuit 22 a polarity order switching signal PCH such that a pulse of positive polarity is produced at the time window M24T and a pulse of negative polarity is produced at the succeeding time window M25T, as shown in Figure 6G. In practice, when the 24th pulse M24 is supplied to the decoder 20 from the variable frequency divider 11, it becomes of "H" (high) logic level whereby the polarity switching signal PCH designates positive polarity, while when the 25th pulse M25 arrives thereat, it becomes of "L" (low) logic level whereby the polarity switching signal PCH designates negative polarity. The horizontal synchronising signal HSYNC is supplied to the polarity switching circuit 22 so that, when the horizontal synchronising signal HSYNC rises to the logic level "H", the polarity switching circuit 22 supplies to an output control circuit 23 a voltage signal VV of a predetermined voltage value (for example, ±2.5 V) having a polarity designated by the polarity order switching signal PCH.

On the basis of the judgement that the horizontal synchronising signal HSYNC rises at the reference timing $t_0$, the decoder 20 delivers time data TOT of 2 bits of logic level "H" to the shift register 21, whereby, during a period in which the shift register 21 carries out a shifting operation twice, the shift register 21 produces an output control signal SC of logic level "H" at its output terminal and then supplies this output control signal SC to the output control circuit 23. At that time, under the condition that the output control signal SC is of logic level "H", the output control circuit 23 is turned on to pass therethrough the voltage signal VV delivered from the polarity switching circuit 22 and deliver the voltage signal VV as the AFC error signal S8.

The shift register 21 receives the horizontal synchronising signal HSYNC as a latch signal so that, when the horizontal synchronising signal HSYNC rises to logic level "H", in accordance with its rising-up, the shift register 21 latches therein the time data TDT. At the same time, the shift register 21 carries out the shifting operation on the basis of a clock pulse CLK which is produced from the variable frequency divider 11 each time the time window is changed. As a result, when the time data TDT is latched, the shift register 21 delivers the output control signal SC which becomes of logic level "H" during a period corresponding to those time windows the number of which is the same as the number of bits of the time data TDT counted from the first time window which is latched. Accordingly, in the case of Figure 6G, since the time data TDT of two bits is latched in the shift register 21, the output control circuit 23 is turned on from the beginning of the time window M24T to the end of the succeeding time window M25T.

As mentioned above, since the voltage signal VV which becomes positive and negative sequentially is supplied to the output control circuit 23 which is turned on at the time windows M24T and M25T, the output control circuit 23 produces the AFC error signal S8 in such a way that a positive pulse is produced at the time window M24T and a negative pulse is produced at the succeeding time window M25T.

As shown in Figure 5, the voltage converting circuit 14 is constructed as a parallel circuit formed of a capacitor C1 connected in parallel with a series circuit of a resistor R1 and a capacitor C2. The AFC current source 13 supplies a charge current to the capacitors C1 and C2 when the AFC error signal S8 has a positive polarity, while, when the AFC error signal S8 has a negative polarity, the AFC current source 13 supplies a discharge current to the capacitors C1 and C2. Further, when the AFC error signal S8 is zero, the AFC current source 13 supplies no charge or discharge current to the capacitors C1 and C2. Accordingly, when the pulse widths of the positive pulse and the negative pulse are equal to each other, as shown in Figure 6G, the amount of current flowing into the capacitors C1 and C2 becomes equal to the amount of current flowing out of the capacitors C1 and C2, so that the charged voltages on the capacitors C1 and C2 become zero as a whole. Thus, the AFC current source 13 and the voltage converting circuit 14 carry out a so-called charge pump operation.

As described above, when the rising edge of the horizontal synchronising signal HSYNC is coincident with the reference timing $t_0$, the decoder 20 produces the time data TDT and the polarity order switching signal PCH which make the positive pulse interval and the negative pulse interval become equal to each other, as shown in Figure 6G, so that the AFC error signal S8 allows the charged voltage of the voltage converting circuit 14 to become zero. As a result, the oscillation frequency of the VCO 5 (Figure 1) is not changed, but maintains its value. If, on the other hand, the rising edge of the horizontal synchronising signal HSYNC is moved or shifted to before the reference timing $t_0$, then in correspondence therewith the decoder 20 produces time data TDT and a polarity order switching signal PCH that make the pulse width of the positive pulse expand in response thereto. That is, as shown in Figure 6F, when the rising edge of the horizontal synchronising signal HSYNC is advanced by a time amount T1 to the time window M23T, the decoder 20 delivers a polarity order switching signal PCH whose polarity is changed to be positive, positive and negative in response to the time windows M23T, M24T and M25T, and makes the shift register 21 latch time data TDT of 3 bits of logic level "H' therein. Accordingly, the shift register 21 allows the output control circuit 23 to produce an AFC error signal S8, the pulse width of the positive pulse of which is expanded by the period of the time T1 from the rising edge of the horizontal synchronising signal HSYNC (shown by a hatched area in Figure 6G). As a result, the voltage Vc of the voltage converting circuit 14 is increased by an amount corresponding to the positive pulse interval T1. At that time, the VCO 5 is controlled to increase its oscillation frequency so that the phase of the frequency-divided output S7 from the variable frequency divider 11 is advanced, and the reference timing $t_0$ of the time window M24T thus becomes coincident with the rising edge of the horizontal synchronising signal HSYNC. Thus, when the above condition as described with reference to Figure 6G is attained, the frequency control circuit 10 is set in a stable state.

If, as shown in Figure 6E, the timing of the rising edge of the horizontal synchronising signal HSYNC is advanced relative to the reference timing $t_0$ by an amount of time T2 and is placed within the time window M22T, the decoder 20 supplies to the polarity switching circuit 22 a polarity order switching signal PCH whose polarity is changed in the order of positive, negative, positive and positive relative to the time windows M22T, M23T, M24T and M25T and supplies time data TDT of 4 bits of logic level "H" to the shift register 21. Consequently, the pulse width of the positive pulse of the AFC error signal S8 becomes equal to the period from the timing of the rising edge of the horizontal synchronising signal HSYNC to the end or falling edge of the time window M22T plus the whole time width in the time windows M24T and M25T, while the pulse width of the negative pulse becomes equal to the time width in the time window M23T. Accordingly, on the whole, the pulse width of the positive pulse of the AFC error signal S8 is expanded by an amount corresponding to the time T2 (shown by a hatched area in Figure 6E) representing the amount by which the horizontal synchronising signal HSYNC is advanced from the reference timing $t_0$. Thus, the voltage Vc of the voltage converting circuit 14 is increased by the expanded amount of the pulse width so that the VCO 5 is controlled so that its oscillation frequency is increased by such amount, so that the reference timing $t_0$ of the frequency-divided output S7 derived from the frequency divider 11 may be locked to the rising edge of the horizontal synchronising signal HSYNC.

Further, as shown in Figure 6D, when the horizontal synchronising signal HSYNC rises up in the time window M21T, in response to a time displacement T3 from the reference timing $t_0$ to the rising edge of the horizontal synchronising signal HSYNC, the decoder 20 supplies to the polarity switching circuit 22 a polarity order switching signal PCH which designates the polarity of the signal S8 in the order of positive, negative, positive, positive and positive, in accordance with the time windows M21T, M22T, M23T, M24T and M25T, and makes the shift register 21 latch time data TDT of 5 bits having logic level "H" therein. Accordingly, in this case, the voltage Vc of the voltage converting circuit 14 is raised by an amount corresponding to the advanced time T3.

In like manner, as shown in Figure 6C, when the phase of the horizontal synchronising signal HSYNC is advanced to the time window M20T, the pulse width of the positive pulse is expanded by an amount corresponding to the advanced time T4, so that the voltage Vc of the voltage converting circuit 14 is increased.

As described above, when the phase of the horizontal synchronising signal HSYNC is advanced relative to the reference timing $t_0$, the pulse width of the positive pulse of the AFC error signal S8 is expanded by an amount corresponding to the advanced time such that the voltage Vc of the voltage converting circuit 14 is raised, whereby the oscillation frequency of the VCO circuit 5 is locked to the advance phase.

On the other hand, when the phase of the horizontal synchronising signal HSYNC is delayed relative to the reference timing $t_0$ and the horizontal synchronising signal HSYNC rises up in the interval of the time window M24T as, for example, shown in Figure 6H, the decoder 20 produces a similar polarity order switching signal PCH and similar time data TDT to those described in connection with Figure 6G. As a result, the pulse width of the negative pulse of the AFC error signal S8 is expanded (made longer) by an amount of time TO1 corresponding to the delay of phase than the pulse width of the positive pulse, so that the charging current amount of the capacitors C1 and C2 of the voltage converting circuit 14 is reduced by that amount, lowering the voltage Vc of the voltage converting circuit 14. Consequently, at that time, the VCO 5 (see Figure 1) is controlled so that its oscillation frequency is lowered, whereby the phase of the frequency-divided output S7 from the frequency divider 11 is delayed and the frequency timing $t_0$ may be locked to the rising-up timing of the horizontal synchronising signal HSYNC.

As shown in Figure 6I, when the rising-up timing of the horizontal synchronising signal HSYNC appears in the interval of the time window M25T and the rising-up thereof is delayed by an amount of time TO2 relative to the reference timing $t_0$, the decoder 20 delivers a polarity order switching signal PCH which designates a polarity in the order of positive, positive, negative, negative and negative in response to the time windows M25T, M26T, M27T, M28T and M29T, respectively, and then makes the shift register 21 latch therein time data TDT of 5 bits having logic level "H" in response to these 5 time windows. Accordingly, an AFC error signal S8 is produced in such a way that a positive pulse is produced during a time interval from the rising edge of the horizontal synchronising signal HSYNC to the end or falling edge of the time window M25T and during the time window M26T, and a negative pulse is produced with a pulse width corresponding to the time windows M27T, M28T and M29T. As a result, in the AFC error signal S8, the pulse width of the negative pulse is expanded by an amount corresponding to the pulse width of an amount of time TO2 representing the delay amount of the time of rising of the horizontal synchronising signal HSYNC relative to the reference timing $t_0$. Thus, the voltage Vc of the voltage converting circuit 14 is lowered by the amount of the pulse width TO2 and, therefore, the VCO 5 is controlled such that its oscillation frequency is lowered by that amount. Therefore, in this case also, the frequency control circuit 10 enables the phase of the horizontal synchronising signal HSYNC to be locked to the oscillation output signal S6 of the VCO 5.

Further, as shown in Figure 6J, when the rising-up timing of the horizontal synchronising signal HSYNC is delayed more and appears in the interval of the time window M26T, in order to produce the same AFC error signal S8 in such a way that the pulse width of the negative pulse is expanded by the amount corresponding to the delay time TO3, the decoder 20 delivers a polarity order switching signal PCH which designates a polarity in the order of positive, positive, negative, negative, negative and negative in response to time windows M26T, M27T, M28T, M29T, M30T and M31T, and makes the shift register 21 latch therein time data TDT of 6 bits corresponding to the number of the windows and the logic level of which is "H". Accordingly, in this case also, the voltage Vc of the voltage converting circuit 14 is lowered by an amount corresponding to the time delay TO3 of the horizontal synchronising signal HSYNC, so that the oscillation frequency of the VCO 5 is lowered by such amount and, therefore, the phase of the oscillation output signal S6 can be locked to that of the horizontal synchronising signal HSYNC.

Similarly, when the rising phase of the horizontal synchronising signal HSYNC is further delayed, in response to the time window where the rising-up timing of horizontal synchronising signal HSYNC, appears the decoder 20 produces a corresponding polarity order switching signal PCH and time data TDT by which the pulse width of the negative pulse in the AFC error signal S8 is expanded by an amount corresponding to the phase delay. Thus, the VCO 5 is controlled such that its oscillation frequency is lowered in response thereto.

According to the circuit arrangement as described above, when the rising-up phase of the horizontal synchronising signal HSYNC is advanced or delayed relative to the reference timing $t_0$ of the oscillation frequency signal S6 of the VCO 5, the AFC error signal S8 is formed in such a way that the pulse width of the positive or negative pulse is expanded by a time width corresponding to the amount of advance or delay, whereby a control voltage of a magnitude corresponding to the difference in pulse width between the positive pulse and the negative pulse is supplied to the VCO circuit 5. Thus, it becomes possible for the phase of the oscillation frequency output signal S6 of the VCO 5 to be locked to the phase of the horizontal synchronising signal HSYNC.

While, in the above embodiment, the polarity order switching signal PCH is such that it designates, for each time window, a positive polarity when the logic level is logic "H" and a negative polarity when the logic level is logic "L", the content designated by the polarity order switching signal PCH is not limited to polarity but may be a positive signal level or negative signal level. For example, when the output from the decoder 20 is logic level "H", a signal level of +5 V is designated, while when it is logic "L", a signal level of 0 V is designated. In this case, when the output control circuit 23 is turned off, the signal level of the AFC error signal S8 may be selected to be +2.5 V. In short, it is sufficient for the AFC error signal S8 to adopt three signal levels in accordance with the phase advance or phase delay, and then the first pulse which rises up from the centre signal level and the second pulse which falls down from the central signal level are formed.

In addition to the above circuit arrangement, the frequency control circuit 10 is provided with an AFC-identification (ID) circuit 24 as shown in Figure 1. The AFC-ID circuit 24 restricts the AFC operation of the AFC circuit 12 within a range of a predetermined number of time windows. When the rising phase of the horizontal synchronising signal HSYNC is advanced or delayed by an amount exceeding the above range, the AFC-ID circuit 24 judges that the lock-in operation by the AFC circuit 12 is impossible and then produces a correcting signal S24. The correcting signal S24 is added to the AFC error signal S8 in an adding circuit 25 which is connected between the AFC circuit 12 and the AFC current source 13, whereby the rising-up of the horizontal synchronising signal HSYNC is brought into a tolerable lock-in range.

The above AFC-ID circuit 24 is formed as shown in Figure 7. As shown, the frequency-divided output S7 of the variable frequency divider 11 is supplied to a decoding circuit 26, provided in the AFC-ID circuit 24, in which, as described in connection with Figures 6A and 6B, the 1H period is divided into 1st to 47th time windows and these time windows are used to judge the timing within the 1H period (see also Figures 8A and 8B).

The decoder 26 produces a first flag signal FG1 which, as shown in Figure 8C, under the condition that an interval W1 formed of 5 time windows M23T to M19T and M24T to M28T before and after the reference timing $t_0$ is taken as an AFC tolerable range and each of an advanced interval W2 and a delayed interval W3 is taken as an AFC correcting range, represents these intervals. The first flag signal FG1 becomes logic level "L" in the AFC tolerable range W1 (the time windows M19T to M28T), while it becomes logic level "H" in the AFC correcting ranges W2 (the time windows M1T to M18T) and W3 (the time windows M29T to M47T).

In addition, the decoding circuit 26 produces a second flag signal FG2 which represents the advanced or delayed please relative to the reference timing $t_0$ in the 1H period. As shown in Figure 8D, the second flag signal FG2 takes the interval from the time windows M23T to M1T prior to the reference timing $t_0$ as a phase advanced range W21 and becomes logic level "L", while it takes the interval from the time windows M24T to M47T following the reference timing $t_0$ as a phase delayed range W22 and becomes logic level "H".

The first and second flag signals FG1 and FG2 are each supplied to an ID signal generating circuit 27 which then generates an ID signal (see Figure 8E) having a voltage level corresponding to the logic levels of the first and second flag signals FG1 and FG2. That is, as will be clear from the combination of Figures 8C and 8D, during the AFC tolerable range W1, within the interval of the phase advanced range W21, the logic levels of the first and second flag signals FG1 and FG2 become "L" and "L", while within the phase delayed range W22 the logic levels of the first and second flag signals FG1 and FG2 become "L" and "H", respectively. Thus, during the tolerable range W1, the ID signal (Figure 8E) becomes of zero level. The AFC correcting range W2 exists within the phase advanced range W21 and the logic levels of the first and second flag signals FG1 and FG2 become "H" and "L", whereby the ID signal (Figure 8E) becomes a positive voltage correcting level $CV_H$. Further, the AFC correcting range W3 exists within the phase delayed range W22 and the logic levels of the first and second flag signals FG1 and FG2 become "H" and "H", whereby the ID signal (Figure 8E) is lowered to a negative voltage correcting level $-CV_L$.

As described above, the ID signal generating circuit 27 generates an ID signal, the voltage level of which is changed in response to changes of the logic levels of the first and second flag signals FG1 and FG2. Depending on the range in the 1H period to which the horizontal synchronising signal HSYNC belongs, the ID signal generating circuit 27 delivers as the correcting signal S21 the voltage level of the ID signal at that timing. More specifically, when the horizontal synchronising signal HSYNC rises up in the AFC tolerable range W1 (Figure 8C), the level of the ID signal (Figure 8E) is zero, so that the correcting signal S24 becomes of zero level. However, when the horizontal synchronising signal HSYNC rises up in the AFC correcting range W2 (Figure 8C), the level of the ID signal at that time is the positive correcting voltage level $CV_H$, so that this ID signal of the positive correcting voltage level $CV_H$ is delivered from the AFC-ID circuit 24 as the correcting signal S24. Further, when the horizontal synchronising signal HSYNC rises up in the AFC correcting range W3 (Figure 8C), the level of the ID signal (Figure 8E) is the negative correcting voltage level $-CV_L$, so that this ID signal of the negative correcting voltage level $-CV_L$ is delivered from the AFC-ID circuit 24 as the correcting signal S24.

Accordingly, if the horizontal synchronising signal HSYNC rises up within the AFC tolerable range W1, the correcting signal S24 adds the voltage of zero level to the adding circuit 25, so that the AFC error signal S8 of the AFC circuit 12 is not corrected and is supplied, as it is, through the adding circuit 25 to the AFC current source 13 (Figure 1), whereby AFC operation by the AFC circuit 12 is carried out.

If the horizontal synchronising signal HSYNC rises up within the AFC correcting range W2, the correcting signal S24 adds the positive voltage level $CV_H$ of extremely large magnitude to the adding circuit 25, so that the AFC error signal S8 supplied from the adding circuit 25 to the AFC current source 13 becomes extremely large. In consequence, the voltage Vc of the voltage converting circuit 14 is greatly increased, so that the oscillation frequency of the VCO 5 is increased greatly and rapidly.

When the horizontal synchronising signal HSYNC rises up in the AFC correcting range W3, the correcting signal S24 adds the very low voltage level $-CV_L$ of negative polarity to the adding circuit 25 so that the very low AFC error signal S8 is supplied from the adding circuit 25 to the AFC current source 13. As a result, the voltage Vc of the voltage converting circuit 14 is greatly lowered and the oscillation frequency of the VCO 5 is therefore rapidly and greatly lowered.

According to the circuit arrangement thus made, even when the rising phase (Figure 8B) of the horizontal synchronising signal HSYNC is displaced relative to the phase of the oscillation frequency output signal S6 of the VCO 5, if the displaced amount lies within the AFC tolerable range W1 (Figure 8C), the AFC-ID circuit 24 produces a correcting signal S24 of zero level. As a result, the AFC error signal S8 from the AFC circuit 12 is supplied, without being corrected, to the AFC current source 13, so that the frequency control circuit 10 carries out ordinary AFC operation.

On the other hand, under an unstable operation state such as, for example, when power for the circuit has just been switched on, if the phase of the horizontal synchronising signal HSYNC is extremely advanced relative to the phase of the oscillation frequency output signal S6 of the VCO 5, the ID signal generating circuit 27 produces a correcting signal S24 of the positive voltage $+CV_N$ such that, in the adding circuit 25, the extremely high voltage level is added to the AFC error signal S8 of the AFC circuit 12 so as significantly to increase the oscillation frequency of the VCO 5. As a result, the phase of the horizontal synchronising signal HSYNC is rapidly approximated to that of the oscillation frequency output signal S6 of the VCO 5 so that, when the phase difference therebetween has fallen within the AFC tolerable range W1, the ID signal generating circuit 24 changes the level of the correcting signal S24 to zero, in correspondence therewith, whereby the frequency control circuit 10 carries out ordinary AFC operation.

When the phase of the horizontal synchronising signal HSYNC is extremely delayed relative to the phase of the oscillation frequency output signal S6 of the VCO 5, then in correspondence therewith the ID signal generating circuit 27 delivers a correcting signal S24 of the negative voltage level $-CV_L$ by which the AFC error signal S8 produced from the AFC circuit 12 is greatly lowered to be corrected in the adding circuit 25, whereby the oscillation frequency of the VCO 5 is lowered considerably. As a result, the phase of the horizontal synchronising signal HSYNC is rapidly approximated to the phase of the oscillation frequency output signal S6 of the VCO 5 such that, when the phase difference has fallen within the AFC tolerable range W1, in correspondence therewith, the ID signal generating circuit 27 changes the level of the correcting signal S24 to zero and the frequency control circuit 10 is thus set in normal AFC operation.

In the AFC-ID circuit 24 (Figure 7), the ID signal generating circuit 27 generates a reset signal RS at every 1H period to reset the content of the decoding circuit 26, thereby to eliminate an error of the level change of the correcting signal S24 for the change of the rising-up timing of the horizontal synchronising signal HSYNC.

In the arrangement set forth above, since the pulse widths of two pulses are expanded in response to the amount of phase delay or advance between the horizontal synchronising signal and the oscillation frequency output signal of the VCO, it is possible to generate the AFC error signal by a digital signal processing manner. Thus, it is possible easily to produce a frequency control circuit which is suitable for being formed as an integrated circuit (IC) and which has a high accuracy in phase lock-in operation and a small amount of ripple after lock-in has been achieved.

Further, according to the above-described arrangement, when the phase of the oscillation frequency output signal from the VCO is displaced relative to the phase of the horizontal synchronising signal beyond a range for normal AFC operation, the AFC-ID circuit generates a correcting signal having an extremely large signal level in response to the direction of the displacement, the AFC error signal is corrected by the correcting signal, the oscillation frequency of the VCO is changed greatly, and thus the oscillation frequency output signal of the VCO can easily be locked to the horizontal synchronising signal. Accordingly, even when a VCO having a large scattering is used, just like a case in which a frequency converting circuit is formed on an ID circuit having a large scattering, the VCO can easily be forced to be operated in a locked-in state, whereby a frequency converting circuit can be manufactured with excellent yield.

## Claims

1. Apparatus for controlling the frequency of a voltage controlled oscillator (5) in response to an input signal, the apparatus comprising:
   frequency-divider means (11) for dividing the frequency of an output (S6) of the oscillator (5); and
   control means (12, 13, 14) for phase-comparing an output (S7) of the frequency-divider means (11) with the input signal to produce an error signal (S8) and forming, from the error signal (S8), a control signal (Vc) for controlling the frequency of the oscillator;
   characterised in that:
   the control means (12, 13, 14) is capable of effecting the phase comparison between the output (S7) of the frequency-divider means (11) and the input signal which is a horizontal synchronising signal (HSYNC) of a video signal;
   the frequency-divider means (11) is operative to establish a plurality of successive time windows;
   the control means (12, 13, 14) is operative to form the control signal (Vc) by generating an error signal (S8) which assumes a first signal level in synchronism with the horizontal synchronising signal (HSYNC) and thereafter assumes either the first signal level or a second signal level in each successive time window as necessary to form the control signal (Vc), the first and second levels both being different from a third level that will produce no change in the frequency of the oscillator (5), and the control signal (Vc) being formed in accordance with the difference in the durations of the intervals in which the error signal (S8) assumes the first and second levels so that the control signal controls the frequency of the oscillator (5) in accordance with the frequency of the horizontal synchronising signal (HSYNC); and
   correction signal generating means (24) is provided for forming a correcting signal (S24) to be added to the error signal (S8) when the phase of the horizontal synchronising signal (HSYNC) is beyond a predetermined range.

2. Apparatus according to claim 1, wherein the control means (12, 13, 14) is operative to expand the duration of the first signal level when the phase of the horizontal synchronising signal (HSYNC) is advanced relative to the output (S6) of the oscillator (5) and to expand the duration of the second signal level when the phase of the horizontal synchronising signal (HSYNC) is delayed relative to the output (S6) of the oscillator (5).

3. Apparatus according to claim 1 or claim 2, wherein the dividing ratio of the frequency-divider means (11) is variable.

4. Apparatus according to claim 1, claim 2 or claim 3, wherein the control means (12, 13, 14) comprises current source means (13) connected to be supplied with the error signal (S8) and a voltage converting means (14) connected between the current source means (13) and the oscillator (5) to perform a charge pump operation.

## Revendications

1. Appareil pour commander la fréquence d'un oscillateur commandé en fréquence (5) en réponse à un signal d'entrée, l'appareil comprenant :

   un moyen diviseur de tension (11) pour diviser la fréquence d'une sortie (S6) de l'oscillateur (5) ; et

   un moyen de commande (12, 13, 14) pour comparer en phase une sortie (S7) du moyen diviseur de fréquence (11) au signal d'entrée afin de produire un signal d'erreur (S8) et de former, à partir du signal d'erreur (S8), un signal de commande (Vc) pour commander la fréquence de l'oscillateur ;

   caractérisé en ce que :

   le moyen de commande (12, 13, 14) peut effectuer la comparaison de phase entre la sortie (S7) du moyen diviseur de fréquence (11) et le signal d'entrée qui est un signal de synchronisation horizontale (HSYNC) d'un signal vidéo ;

   le moyen diviseur de fréquence (11) peut fonctionner pour établir une pluralité de fenêtres temporelles successives ;

   le moyen de commande (12, 13, 14) peut fonctionner pour former le signal de commande (Vc) en générant un signal d'erreur (S8) qui prend un premier niveau de signal en synchronisation avec le signal de synchronisation horizontale (HSYNC) puis qui prend ensuite soit le premier niveau de signal, soit un second niveau de signal dans chaque fenêtre temporelle successive, selon la nécessité pour former le signal de commande (Vc), les premier et second niveaux étant tous deux différents d'un troisième niveau qui ne produira aucun changement dans la fréquence de l'oscillateur (5) et le signal de commande (Vc) étant formé en fonction de la différence des durées des intervalles dans lesquels le signal d'erreur (S8) prend les premier et second niveaux de telle sorte que le signal de commande commande la fréquence de l'oscillateur (5) en fonction de la fréquence du signal de synchronisation horizontale (HSYNC) ; et

   un moyen de génération de signal de correction (24) est prévu pour former un signal de correction (S24) qui doit être ajouté au signal d'erreur (S8) lorsque la phase du signal de synchronisation horizontale (HSYNC) est au-delà d'une plage prédéterminée.

2. Appareil selon la revendication 1, dans lequel le moyen de commande (12, 13, 14) peut fonctionner pour dilater la durée du premier niveau de signal lorsque la phase du signal de synchronisation horizontale (HSYNC) est avancée par rapport à la sortie (S6) de l'oscillateur (5) et pour dilater la durée du second niveau de signal lorsque la phase du signal de synchronisation horizontale (HSYNC) est retardée par rapport à la sortie (S6) de l'oscillateur (5).

3. Appareil selon la revendication 1 ou 2, dans lequel le rapport de division du moyen diviseur de fréquence (11) est variable.

4. Appareil selon la revendication 1, 2 ou 3, dans lequel le moyen de commande (12, 13, 14) comprend un moyen de source de courant (13) qui est connectée pour être acheminée avec le signal d'erreur (S8) et un moyen convertisseur de tension (14) qui est connecté entre le moyen de source de courant (13) et l'oscillateur (5) afin d'effectuer l'opération de pompage de charge.

## Patentansprüche

1. Vorrichtung zur Steuerung der Frequenz eines spannungsgesteuerten Oszillators (5) in Abhängigkeit von einem Eingangssignal mit

   einer Frequenzteilereinrichtung (11) zum Teilen der Frequenz des Ausgangssignals (S6) des Oszillators (5) und

   einer Steuereinrichtung (12, 13, 14) zum Vergleichen der Phase des Ausgangssignals (S7) der Frequenzteilereinrichtung (11) mit der Phase des Eingangssignals zur Gewinnung eines Fehlersignals (S8) und zur Bildung eines Steuersignals (Vc) für die Steuerung des Oszillators aus dem Fehlersignal (S8),

   dadurch gekennzeichnet,

   daß die Steuereinrichtung (12, 13, 14) den Phasenvergleich zwischen dem Ausgangssignal (S7) der Frequenzteilereinrichtung (11) und dem von einem horizontalen Synchronisiersignal (HSYNC) eines Videosignals gebildeten Eingangssignal durchführen kann,

   daß die Frequenzteilereinrichtung (11) eine Mehrzahl aufeinanderfolgender Zeitfenster bildet,

   daß die Steuereinrichtung (12, 13, 14) das Steuersignal (Vc) durch Erzeugung eines Fehlersignal bildet, das synchron mit dem horizontalen Synchronisiersignal (HSYNC) einen ersten Signalpegel und danach in jedem der aufeinanderfolgenden Zeitfenster entweder den ersten Signalpegel oder einen zweiten Signalpegel annimmt, wobei sowohl der erste als auch der zweite Signalpegel sich von einem dritten Signalpegel unterscheiden, der keine Frequenzänderung des Oszillators (5) bewirkt, und wobei das Steuersignal (Vc) in Abhängigkeit von der Differenz der Zeitdauern der Intervalle gebildet wird, in denen das Fehlersignal (S8) den ersten und den zweiten Signalpegel annimmt, derart daß das Steuersignal die Frequenz des Oszillators (5) in Abhängigkeit von der Frequenz des horizontalen Synchronisiersignals (HSYNC) steuert,

und daß eine Einrichtung (24) zur Erzeugung eines Korrektursignals (S24) vorgesehen ist, das zu dem Fehlersignal (S8) addiert wird, wenn die Phase des horizontalen Synchronisiersignals (HSYNC) außerhalb eines vorbestimten Bereichs liegt.

2. Vorrichtung nach Anspruch 1, bei der die Steuereinrichtung (12, 13, 14) die Dauer des ersten Signalpegels ausdehnt, wenn die Phase des horizontalen Synchronisiersignals (HSYNC) gegenüber dem Ausgangssignal (S6) des Oszillators (5) voreilt, hingegen die Dauer des zweiten Signalpegels ausdehnt, wenn die Phase des horizontalen Synchronisiersignals (HSYNC) gegenüber dem Ausgangssignal (S6) des Oszillators (5) nacheilt.

3. Vorrichtung nach Anspruch 1 oder 2, bei der das Teilerverhältnis der Frequenzteilereinrichtung (11) variabel ist.

4. Vorrichtung nach Anspruch 1, 2 oder 3, bei der die Steuereinrichtung (12, 13, 14) eine mit dem Fehlersignal (S8) beaufschlagte Stromquelle (13) sowie einen zwischen dieser Stromquelle (13) und dem Oszillator (5) angeordneten Spannungswandler (14) zur Durchführung eines Ladungs-Pumpvorgangs aufweist.

F I G. 1

FIG. 2A

FIG. 2B

FIG. 3A

FIG. 3B

FIG. 4A

FIG. 4B

FIG. 4C1

FIG. 4C2

FIG. 4C3

FIG. 4C47

EP 0 140 567 B1

*F I G. 5*

*F I G. 7*

FIG. 6A

FIG. 6B

FIG. 6C

FIG. 6D

FIG. 6E

FIG. 6F

FIG. 6G

FIG. 6H

FIG. 6I

FIG. 6J

EP 0 140 567 B1

F/G. 8A

F/G. 8B

F/G. 8C

F/G. 8D

F/G. 8E